(19) Europäisches Patentamt
European Patent Office
Office européen des brevets

(11)  **EP 1 562 312 B1**

(12)  **EUROPÄISCHE PATENTSCHRIFT**

(45) Veröffentlichungstag und Bekanntmachung des Hinweises auf die Patenterteilung:
**21.05.2008  Patentblatt 2008/21**

(51) Int Cl.:
*H04B 10/158* (2006.01)    *H04L 25/02* (2006.01)
*H04L 1/00* (2006.01)

(21) Anmeldenummer: **05090014.1**

(22) Anmeldetag: **28.01.2005**

(54) **Empfängerschaltung sowie Verfahren zu deren Betrieb**

Receiver cicuit and method of operation

Récepteur optique et méthode d'opération

(84) Benannte Vertragsstaaten:
**DE FR GB**

(30) Priorität: **30.01.2004   US 540759 P**

(43) Veröffentlichungstag der Anmeldung:
**10.08.2005   Patentblatt 2005/32**

(73) Patentinhaber: **Infineon Technologies AG**
**81669 München (DE)**

(72) Erfinder: **Schrödinger, Karl**
**14089 Berlin (DE)**

(74) Vertreter: **Müller, Wolfram Hubertus et al**
**Patentanwälte**
**Maikowski & Ninnemann**
**Postfach 15 09 20**
**10671 Berlin (DE)**

(56) Entgegenhaltungen:
**US-A- 4 608 542**        **US-A- 5 864 416**
**US-A1- 2002 141 022**    **US-B1- 6 266 172**
**US-B1- 6 377 618**

**Beschreibung**

Die Erfindung bezieht sich auf eine Empfängerschaltung sowie auf ein Verfahren zum Betreiben einer Empfängerschaltung. Empfängerschaltungen werden beispielsweise in der optischen Nachrichtentechnik eingesetzt, um das von einem optoelektronischen Wandler gelieferte elektrische Messsignal zu verstärken und anschließend weiterzuverarbeiten.

Das US Patent 4,608,542 beschreibt eine Empfängerschaltung mit einem adaptiven Verstärker für ein Datensignal, wobei die Bandbreite des Verstärkers an die Datenrate des Datensignals angepasst werden kann.

In US-Patent 5,864,416 wird ein Aufbau für eine Empfängerschaltung mit allen Merkmalen des Oberbegriffs des Anspruchs 1 beschrieben. In Abhängigkeit von der Datenrate wird die Bandbreite des Verstärkers so angepasst, dass die Bandbreite nicht größer als für die mittels eines Clock Recovery Circuits bestimmte Datenrate notwendig ist.

Die US Patent Application 2002/0141022 A1 offenbart eine dritte Möglichkeit, eine Empfängerschaltung mit einem adaptiven Verstärker aufzubauen.

Aufgabe der Erfindung:

Aufgabe der Erfindung ist es, eine Empfängerschaltung anzugeben, die ein minimales Rauschen aufweist. Außerdem soll die Empfängerschaltung möglichst einfach und kostengünstig herstellbar sein und digital bzw. weitestgehend digital arbeiten.

Zusammenfassung der Erfindung:

Die angegebene Aufgabe wird erfindungsgemäß durch eine Empfängerschaltung mit den Merkmalen des Anspruchs 1 gelöst.

Bekanntermaßen hängen die Bandbreite und das Rauschverhalten von Verstärkereinrichtungen miteinander zusammen. Konkret tritt bei einer sehr großen Bandbreite in aller Regel auch ein sehr großes Rauschen der Verstärkereinrichtung auf. Um nun ein optimales Rauschverhalten bzw. ein minimales Rauschen der Empfängerschaltung zu gewährleisten, wird erfindungsgemäß die Bandbreite der Verstärkereinrichtung so gering wie möglich eingestellt, nämlich stets nur gerade so groß, dass das Datensignal unverfälscht verstärkt werden kann. Ein unverfälschtes Verstärken des Datensignals wird dadurch erreicht, dass die Bandbreite der Verstärkereinrichtung gerade so groß wie die Datenrate des Datensignals eingestellt wird. Bei der erfindungsgemäßen Empfängerschaltung wird bei einer hohen Datenrate des Datensignals also eine große Bandbreite der Verstärkereinrichtung eingestellt, wohingegen bei einer kleinen Datenrate des Datensignals eine nur kleine Bandbreite eingestellt wird.

Zusammengefasst besteht der Kern der Erfindung also darin, durch eine Anpassung der Bandbreite der Verstärkereinrichtung an die jeweilige Datenrate des Datensignals ein optimales Rauschverhalten der Empfängerschaltung zu bewirken.

Dafür ist bei der Erfindung vorgesehen, dass die Steuereinrichtung eingangsseitig einen Datenkorrelator aufweist. Dieser Datenkorrelator wird eingangsseitig mit dem Datensignal oder mit dem mit der Verstärkereinrichtung der Empfängerschaltung verstärkten Datensignal beaufschlagt.

Nachfolgend wird mit dem Begriff "Datensignal" sowohl das unverstärkte, also am Eingang der Empfängerschaltung anliegende Datensignal, als auch das mit der Verstärkereinrichtung der Empfängerschaltung verstärkte Datensignal bezeichnet; soweit nachfolgend also kurz von dem "Datensignal" die Rede ist, so kann es sich um das bereits verstärkte oder alternativ um das unverstärkte Datensignal handeln. Zur Messung der Datenrate des Datensignals und zur Regelung der Bandbreite der Verstärkereinrichtung sind prinzipiell beide Signale geeignet.

Der Datenkorrelator unterwirft das Datensignal einer Autokorrelation und bildet dabei zumindest ein dem Korrelationsergebnis entsprechendes digitales Korrelationssignal, das nachfolgend zur Bestimmung der Datenrate des Datensignals herangezogen wird.

Dafür weist die Steuereinrichtung eine dem Datenkorrelator nachgeordnete Bandbreiten-Kontrolleinrichtung auf, die das Korrelationssignal des Datenkorrelators zeitlich mittelt und aus dem zeitlich gemittelten Korrelationssignal ein Datenratemesssignal zur Ansteuerung der Verstärkereinrichtung erzeugt.

Vorzugsweise bildet der Datenkorrelator mit dem Datensignal zumindest ein phasenverschobenes Hilfssignal. Anschließend unterwirft der Datenkorrelator das Datensignal und das zumindest eine phasenverschobene Hilfssignal einer Korrelation.

Besonders einfach und damit kostengünstig lässt sich der Datenkorrelator durch Phasenschieber und D-Flip-Flops bilden. Die Phasenschieber dienen dabei zum Erzeugen der phasenverschobenen Hilfssignale. Die D-Flip-Flops dienen zum Bilden der Korrelationssignale.

Um die Datenrate des Datensignals möglichst genau bestimmen zu können, weist der Datenkorrelator vorzugsweise eine Mehrzahl an D-Flip-Flops und eine Mehrzahl an Phasenschiebern auf. Mit den Phasenschiebern erzeugt der Datenkorrelator eine Mehrzahl an phasenverschobenen Hilfssignalen mit gegenüber dem Datensignal unterschiedlicher Phasenverschiebung. Mit der Mehrzahl an phasenverschobenen Hilfssignalen kann dann mit den D-Flip-Flops eine Mehrzahl an Korrelationssignalen gebildet werden.

Vorzugsweise ist die Bandbreiten-Kontrolleinrichtung derart ausgestaltet, dass sie die Korrelationssignale jeweils zeitlich mittelt und mit jedem gemittelten Korrelationssignal jeweils ein binäres Schwellwertsignal erzeugt, das angibt, ob der zeitliche Mittelwert des jeweiligen Korrelationssignals kleiner oder größer als ein vorgegebener Schwellwert ist.

Die zeitliche Mittlung der Korrelationssignale kann in der Bandbreiten-Kontrolleinrichtung beispielsweise mit Tiefpässen oder Integratoren durchgeführt werden.

Zur Bildung der binären Schwellwertsignale weist die Bandbreiten-Kontrolleinrichtung vorzugsweise Komparatoren auf.

Im Übrigen wird es als vorteilhaft angesehen, wenn die Steuereinrichtung eine State Machine aufweist, die beispielsweise durch eine Mikroprozessoranordnung gebildet ist. Die State Machine ist der Bandbreiten-Kontrolleinrichtung nachgeordnet und führt eine Regelprozedur durch, mit der in Abhängigkeit von dem Datenratemesssignal der Bandbreiten-Kontrolleinrichtung die optimale Bandbreite der Verstärkereinrichtung eingestellt wird.

Wertet die Steuereinrichtung das bereits verstärkte Datensignal aus, so wird vorzugsweise sichergestellt, dass bei der erstmaligen Inbetriebnahme der Empfängerschaltung die Verstärkereinrichtung zunächst mit maximaler Bandbreite betrieben wird. Erst wenn nach einem Messen der tatsächlichen Bandbreite des Datensignals feststeht, dass eine kleinere Bandbreite der Verstärkereinrichtung ausreicht, wird die Bandbreite der Verstärkereinrichtung reduziert. Würde nämlich bei einer Neuinbetriebnahme der Empfängerschaltung die Ansteuerung der Verstärkereinrichtung mit einer zu kleinen Bandbreite "begonnen" werden, so würde das Datensignal durch die Verstärkereinrichtung verfälscht werden, so dass die Datenrate des verstärkten Datensignals nicht mehr der Datenrate des unverstärkten, also ursprünglichen Datensignals entsprechen würde; denn die Verstärkereinrichtung würde das Frequenzspektrum und damit die Datenrate des Datensignals quasi "abschneiden". Eine Regelung der Bandbreite der Verstärkereinrichtung mit verstärkten Datensignal wäre dann fehlerbehaftet.

Die Einstellung der Bandbreite der Verstärkereinrichtung nach einer Neuinbetriebnahme der Empfängerschaltung wird vorteilhaft mit der State Machine durchgeführt.

Um zu vermeiden, dass eine Fehleinstellung der Bandbreite der Verstärkereinrichtung zu einem Regelfehler der Steuereinrichtung führen kann, wird alternativ die Steuereinrichtung mit dem unverstärkten Datensignal beaufschlagt. Selbst wenn die Verstärkereinrichtung die Datenrate des Datensignals verändert oder verfälscht, so wird die Einstellung der "passenden" Bandbreite durch die Steuereinrichtung davon nicht betroffen.

Die erfindungsgemäße Empfängerschaltung kann beispielsweise Teil eines optischen Empfangselementes mit einem optoelektrischen Wandler sein. In diesem Fall ist die erfindungsgemäße Empfängerschaltung dem optoelektrischen Wandler nachgeordnet und verstärkt dessen Ausgangssignale.

Im Übrigen wird es als vorteilhaft angesehen, wenn die Empfängerschaltung zusätzlich eine Umschaltvorrichtung zum Umschalten des Rauschens bzw. zum Verändern des Rauschverhaltens der Verstärkereinrichtung aufweist. Ein Umschalten des Rauschens bzw. ein Verändern des Rauschverhaltens kann beispielsweise durch ein Umschalten oder Verändern des Arbeitspunktes der Verstärkereinrichtung erfolgen. Mit einem solchen Umschalten bzw. Verändern des Arbeitspunktes kann die Empfindlichkeit der Empfängerschaltung weiter optimiert werden.

Die Erfindung bezieht sich darüber hinaus auf ein Verfahren zum Betreiben einer Empfängerschaltung. Das Verfahren umfasst dabei die Merkmale des Anspruchs 11.

Erfindungsgemäß ist bezüglich eines solchen Betriebsverfahrens vorgesehen, dass ein Datensignal der Empfängerschaltung mit einer Verstärkereinrichtung unter Bildung eines verstärkten Datensignals verstärkt wird. Dabei wird die Datenrate des verstärkten oder unverstärkten Datensignals mittels einer Autokorrelation und zeitlicher Mittelung gemessen, und es wird die Bandbreite der Verstärkereinrichtung derart eingestellt, dass die Bandbreite der Verstärkereinrichtung der gemessenen Datenrate entspricht.

Durch ein Anpassen der Bandbreite der Verstärkereinrichtung an die jeweilige Datenrate des Datensignals lässt sich - wie oben bereits erläutert - ein optimales Rauschverhalten der Empfängerschaltung erreichen.

Bezüglich der Vorteile des erfindungsgemäßen Verfahrens wird auf die obigen Ausführungen im Zusammenhang mit der erfindungsgemäßen Empfängerschaltung verwiesen. Entsprechendes gilt für vorteilhafte Ausgestaltungen des erfindungsgemäßen Verfahrens.

Ausführungsbeispiel:

Zur Erläuterung der Erfindung zeigen

Figur 1        ein Ausführungsbeispiel für eine erfindungsgemäße Empfängerschaltung, mit der sich auch das erfindungsgemäße Verfahren zum Betreiben einer Empfängerschaltung sowie das erfindungsgemäße Verfahren zum Charakterisieren der Datenrate eines digitalen Datensignals durchführen lässt;

Figur 2          ein Ausführungsbeispiel für einen Datenkorrelator einer Steuereinrichtung der Empfängereinrichtung gemäß Figur 1;

Figur 3          ein Ausführungsbeispiel für eine Bandbreiten-Kontrolleinrichtung der Steuereinrichtung der Empfängerschaltung gemäß Figur 1;

Figur 4          zeitliche Verläufe der in der Empfängerschaltung gemäß Figur 1 aufretenden Signale sowie

Figuren 5-10      beispielhaft Signalverläufe bei einem Betrieb der Empfängerschaltung gemäß Figur 1 bei unterschiedlichen Datenraten.

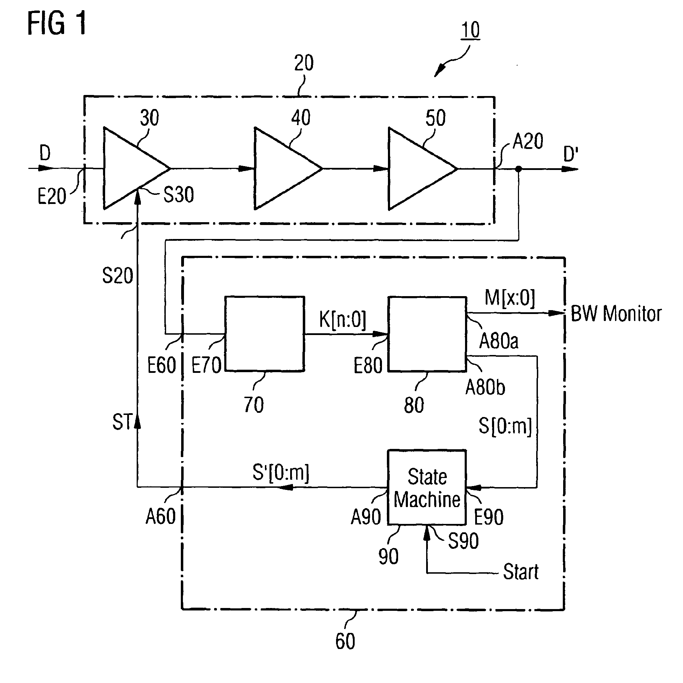

In der Figur 1 erkennt man eine Empfängerschaltung 10, die beispielsweise einen Bestandteil eines optischen Empfangselementes bildet. Dies bedeutet, dass die Empfängerschaltung zur Verarbeitung eines Messsignals eines optoelektronischen Wandlers geeignet ist.

Die Empfängerschaltung 10 weist eingangssseitig eine Verstärkereinrichtung 20 auf, an deren Eingang E20 ein Datensignal D in die Empfängerschaltung 10 eingespeist wird. Das Datensignal D wird beispielsweise von einem in der Figur 1 nicht dargestellten optoelektronischen Wandler eines optischen Empfangselementes gebildet.

Die Verstärkereinrichtung 20 weist drei Verstärker 30, 40 und 50 auf, die in Reihe geschaltet sind und somit eine Verstärkerkette bilden. Der von der Eingangsseite gesehen erste Verstärker 30 ist ein über einen Steuereingang S30 ansteuerbarer Verstärker. Durch Vorgabe eines Steuersignals ST am Steuereingang S30 lässt sich die Bandbreite und damit das Rauschverhalten des Verstärkers 30 festlegen.

Die Bandbreite und damit das Rauschverhalten des Verstärkers 30 können beispielsweise durch ein Umschalten eines Transimpedanzwiderstandes des Verstärkers 30 verändert werden, falls es sich bei dem Verstärker 30 um einen Transimpedanzverstärker handelt.

Das Umschalten der Verstärkung und der Bandbreite eines Verstärkers ist in der parallelen US-Patentanmeldung 10/649,409 (Anmeldetag 27. August 2003) beschrieben, deren Inhalt hiermit vollständig in diese Anmeldung aufgenommen wird.

Alternativ oder zusätzlich kann eine Umschaltung des Arbeitspunktes des Verstärkers 30 in Abhängigkeit vom Steuersignal ST am Steuereingang S30 erfolgen. Beispielsweise können der Strom und/oder Widerstände des Verstärkers 30 umgeschaltet oder Kapazitäten zugeschaltet werden.

Die übrigen Verstärker 40 und 50 können alternativ ebenfalls einstellbar bzw. verstellbar ausgebildet sein.

Am Ausgang A20 der Verstärkereinrichtung 20 wird von der Verstärkereinrichtung 20 ein verstärktes Datensignal D' abgegeben. Dieses verstärkte Datensignal D' gelangt über eine Rückkoppelschleife zu einem Eingang E60 einer Steuereinrichtung 60. Die Steuereinrichtung 60 weist einen Steuerausgang A60 auf, der mit einem Steuereingang S20 der Verstärkereinrichtung 20 und somit mit dem Steueranschluss S30 des ersten Verstärkers 30 in Verbindung steht.

Die optische Empfängerschaltung 10 gemäß der Figur 1 wird wie folgt betrieben: Das eingangsseitig an der Verstärkereinrichtung 20 anliegende Datensignal D wird von der Verstärkereinrichtung 20 verstärkt und am Ausgang A20 der Verstärkereinrichtung 20 abgegeben.

Die Datenrate f des verstärkten Datensignals D' wird von der Steuereinrichtung 60 gemessen. Anschließend erzeugt die Steuereinrichtung 60 an ihrem Steuerausgang A60 das Steuersignal ST, mit dem die Bandbreite des ersten Verstärkers 30 derart eingestellt wird, dass die Bandbreite des ersten Verstärkers 30 der Datenrate f des verstärkten Datensignals D' entspricht. Darunter ist zu verstehen, dass die Bandbreite des ersten Verstärkers 30 so gering wie möglich ist und zum Verstärken des Datensignals D gerade noch ausreicht. Durch Einstellen einer minimal möglichen Bandbreite lässt sich ein minimales Rauschen des Verstärkers 30 erreichen, wodurch das Gesamtrauschen der Verstärkereinrichtung 20 ebenfalls minimiert wird.

Zum Erzeugen des Steuersignals ST weist die Steuereinrichtung 60 einen Datenkorrelator 70 auf, dessen Eingang E70 den Eingang E60 der Steuereinrichtung 60 bildet. Ausgangsseitig ist der Datenkorrelator 70 mit einem Eingang E80 einer Bandbreiten-Kontrolleinrichtung 80 verbunden. Die Bandbreiten-Kontrolleinrichtung 80 weist einen Ausgang A80a auf, an dem sie ein die Datenrate des Datensignals D' angebendes bzw. charakterisierendes Messsignal M[x:0] zur Anzeige an einem Monitor oder einer sonstigen externen Anzeige abgibt.

Die Bandbreiten-Kontrolleinrichtung 80 weist darüber hinaus einen weiteren Ausgang A80b auf, an dem sie ein die Bandbreite des Datensignals D' angebendes bzw. charakterisierendes Datenrate-Messsignal S[0:m] erzeugt und an einen Eingang E90 einer nachgeordneten State Machine 90 abgibt.

Die State Machine 90 weist einen Steuereingang S90 auf, über der der State Machine 90 ein "Startsignal" übermittelt werden kann. Ein solches "Startsignal" gibt an, dass die optische Empfängerschaltung 10 neu in Betrieb genommen wird. Dieses "Startsignal" kann z.B. beim Einschalten der Empfängerschaltung automatisch erzeugt werden oder bei Bedarf vom System selbst generiert werden ("power on reset").

Ein Ausgang A90 des State Machine 90 bildet den Steuerausgang A60 der Steuereinrichtung 60.

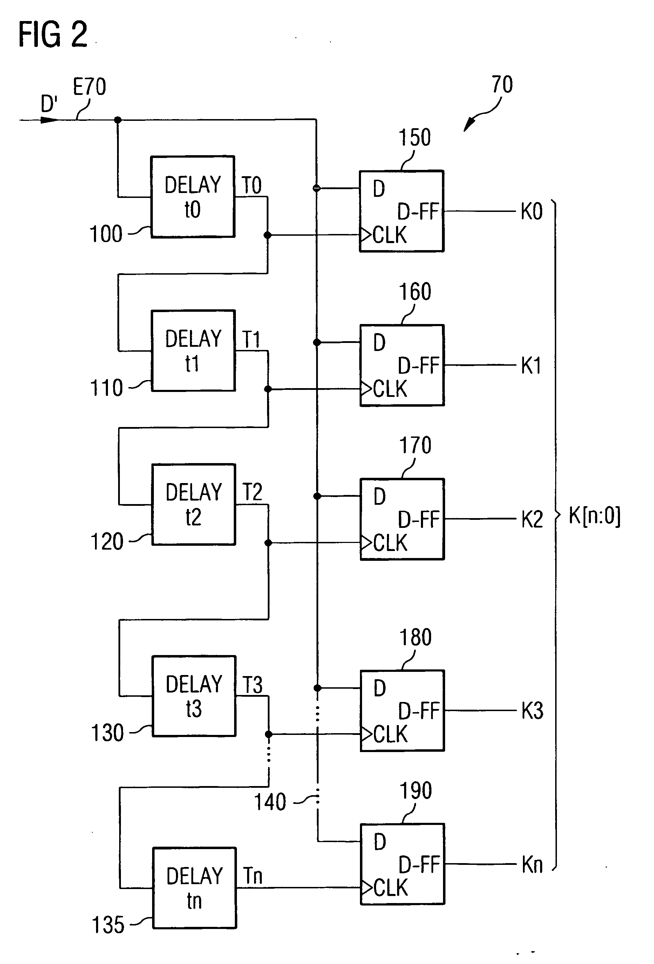

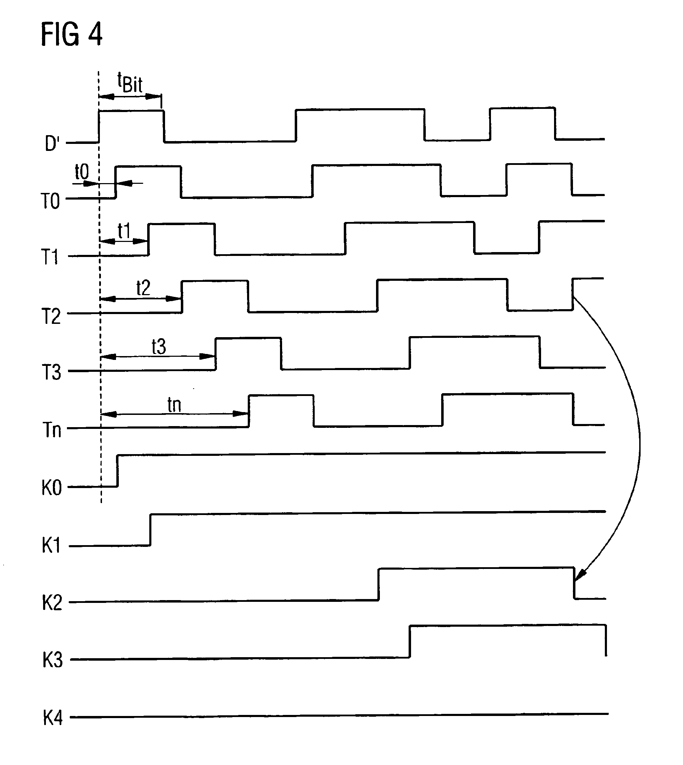

Im Zusammenhang mit der Figur 2 ist die Funktionsweise des Datenkorrelators 70 gezeigt. Man erkennt fünf Phasenschieber 100, 110, 120, 130 und 135, die in Reihe geschaltet sind. Das am Eingang E70 des Datenkorrelators 70 anliegende, verstärkte Datensignal D' durchläuft somit zunächst den Phasenschieber 100 und wird um eine Zeitspanne t0 phasenverschoben. Am Ausgang des Phasenschiebers 100 bildet sich somit ein phasenverschobenes Hilfssignal T0. Der Verlauf des phasenverschobenen Hilfssignals T0 und zum Vergleich der Verlauf des verstärkten Datensignals D' sind in der Figur 4 erkennbar.

Das phasenverschobene Hilfssignal T0 gelangt darüber hinaus zu dem zweiten Phasenschieber 110, der mit dem Phasenschieber 100 beispielsweise baugleich ist und ebenfalls eine Phasenverschiebung um die Zeitspanne t0 hervorruft.

Am Ausgang des zweiten Phasenschiebers 110 bildet sich somit ein zweites phasenverschobenes Hilfssignal T1, das gegenüber dem Datensignal D' eine Phasenverschiebung von $\Delta\Phi = t1 = 2 * t0$ aufweist.

Das zweite phasenverschobene Hilfssignal T1 gelangt außerdem zu dem dritten Phasenschieber 120, zum vierten Phasenschieber 130 sowie zu dem fünften Phasenschieber 135, die jeweils eine zeitliche Verschiebung um weitere Zeitspannen t0 hervorrufen.

Am Ausgang des dritten Phasenschiebers 120 entsteht somit ein drittes phasenverschobenes Hilfssignal T2 mit einer Phasenverschiebung $t2 = 3*t0$, am vierten Phasenschieber 130 ein viertes phasenverschobenes Hilfssignal T3 mit einer Phasenverschiebung $t3 = 4*t0$ und am fünften Phasenschieber 135 ein fünftes phasenverschobenes Hilfssignal Tn mit einer Phasenverschiebung $tn = 5*t0$.

In der Figur 2 ist durch Punkte 140 dargestellt, dass der Datenkorrelator 70 nicht nur fünf Phasenschieber, sondern darüber hinaus noch weitere Phasenschieber aufweisen könnte.

Wie sich in der Figur 2 darüber hinaus erkennen lässt, ist jedem der Phasenschieber 100, 110, 120, 130 und 135 jeweils ein D-Flip-Flop 150, 160, 170, 180 und 190 nachgeschaltet. Konkret liegen die ausgangsseitig von den Phasenschiebern abgegebenen phasenverschobenen Hilfssignale T0, T1, T2, T3 und Tn jeweils an einem Triggereingang T der D-Flip-Flops 150, 160, 170, 180 und 190 an. Die Triggereingänge T reagieren jeweils auf einen positiven Flankenanstieg; sie sind also auf eine positive Flanke getriggert.

Die fünf D-Flip-Flops 150, 160, 170, 180 und 190 weisen jeweils einen D-Eingang auf, der mit dem verstärkten Datensignal D' beaufschlagt ist.

Die Funktionsweise des Datenkorrelators 70 ist nun wie folgt: Das Datensignal D' gelangt zu den D-Eingängen der D-Flip-Flops, die den jeweiligen Signalpegel des Datensignals D' an ihren Ausgang durchschalten, wenn das am jeweiligen Triggereingang T anliegende phasenverschobene Hilfssignal T0, T1, T2, T3 bzw. Tn einen positiven Flankenanstieg aufweist. An den Ausgängen der D-Flip-Flops bilden sich somit digitale Korrelationssignale K0, K1, K2, K3 und Kn.

Der zeitliche Verlauf der phasenverschobenen Hilfssignale T0 bis Tn sowie der digitalen Korrelationssignale K0 bis Kn ist in der Figur 4 dargestellt. Bei dem Beispiel gemäß der Figur 4 ist die Datenrate f des Datensignals D derart gewählt, dass die Bitlänge $t_{BIT}$ des Datensignal D deutlich größer als die Phasenverschiebung bzw. die Zeitspanne t0 ist.

Dies führt dazu, dass zwischen dem phasenverschobenen Hilfssignal T0 und dem Datensignal D' die Phasenverschiebung derart gering ist, dass bei einem Flankenanstieg des phasenverschobenen Hilfssignals T0 stets ein High-Pegel des Datensignals D' vorliegt. Das digitale Korrelationssignal K0 wird somit bei Vorliegen einer positiven Flanke des phasenverschobenen Hilfssignals T0 auf einen High-Pegel übergehen und dort unverändert verbleiben. Das Korrelationssignal K0 gibt damit an, dass die Phasenverschiebung t0 deutlich kleiner als die Bitlänge $t_{BIT}$ des Datensignals D' ist und dass somit gilt:

$$f < 1/t0$$

Bezüglich des zweiten phasenverschobenen Hilfssignals T1 gilt das zu dem ersten Hilfssignal T0 Ausgeführte entsprechend. Dies bedeutet, dass die Zeitspanne $t1 = 2 * t0$ kleiner als die Bitlänge $T_{BIT}$ des Datensignals D' ist, so dass auch das digitale Korrelationssignal K1 bei Auftreten des ersten positiven Flankenwechsels des Hilfssignals T1 auf einen High-Pegel springen und dort verbleiben wird.

Aus dem dauerhaften Vorliegen des zweiten digitalen Korrelationssignal K1 lässt sich somit ablesen, dass die Bitlänge $t_{BIT}$ des Datensignals D' größer als die Zeitspanne $t1 = 2 * t0$ ist und dass entsprechend die Datenrate f des Datensignals D' kleiner als die der Zeitspanne t1 entsprechende Frequenz ist. Es gilt also:

```
f < 1/t1 = 1/(2*t0)
```

Bezüglich des dritten phasenverschobenen Hilfssignals T2 ist festzustellen, dass die Phasenverschiebung t2 = 3 * t0 größer als die Bitlänge $T_{BIT}$ des Datensignals D' ist. Dies führt dazu, dass bei einem in der Figur 4 dargestellten, ersten Flankenanstieg des phasenverschobenen Hilfssignals T2 das Datensignal D' seinen Signalpegel bereits gewechselt hat und von einem High-Pegel auf einen Low-Pegel gesprungen ist. Bei dem in der Figur 4 dargestellten ersten positiven Flankenanstieg des dritten phasenverschobenen Hilfssignals T2 wird das D-Flip-Flop 170 somit nicht umgeschaltet, so dass das digitale Korrelationssignal K2 zunächst auf einem Low-Pegel verbleibt. Zu einem Umschalten des Korrelationssignals K2 kommt es - wie sich der Figur 4 ebenfalls entnehmen lässt - erst dann, wenn zwei High-Pegel des Datensignals D' unmittelbar hintereinander auftreten. In diesem Fall ist nämlich die zeitliche Länge des High-Pegels des Datensignals D' länger als der zeitliche Versatz t2 des phasenverschobenen Hilfssignals T2, so dass das D-Flip-Flop 170 einen Pegelwechsel vollführt.

Ein Zurücksetzen des D-Flip-Flops 170 auf einen Low-Pegel erfolgt dann, sobald das Datensignal D' nach einer Bitlänge $t_{Bit}$ von einem logischen High-Pegel auf einen logischen Low-Pegel zurückspringt. Das digitale Korrelationssignal K2 weist somit einen rechteckigen Verlauf auf.

Entsprechendes gilt für die in der Figur 4 dargestellten Korrelationssignale K3 und Kn, die sich auf die Phasenschieber 130 und 135 sowie auf die D-Flip-Flops 180 und 190 beziehen.

Zusammengefasst lässt sich damit feststellen, dass die Korrelationssignale nach einem erstmaligen Umschalten auf einen High-Pegel dort endgültig verbleiben, wenn die zugehörige Phasenverschiebung kleiner als die Bitlänge $t_{Bit}$ des Datensignals D ist (vgl. Korrelationssignale K0 und K1). Die übrigen Korrelationssignale, die sich auf Phasenverschiebungen beziehen, die größer als die Bitlänge $t_{Bit}$ des Datensignals D' sind, werden einen rechteckförmigen, also wechselnden Signalverlauf aufweisen.

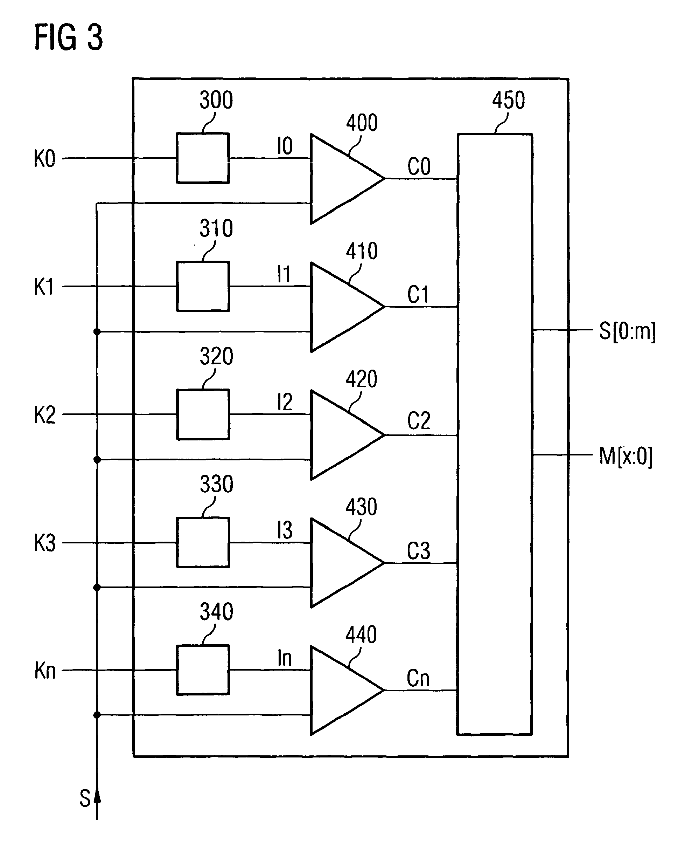

Wie bereits erwähnt, kann der zeitliche Verlauf der Korrelationssignale K0 bis Kn zum Bestimmen der Bitlänge $t_{Bit}$ des Datensignals D' und damit auch zum Bestimmen der Datenrate f des Datensignals D' herangezogen werden. Hierzu dient die Bandbreiten-Kontrolleinrichtung 80 gemäß der Figur 1, die im Detail in der Figur 3 dargestellt ist.

Man erkennt in der Figur 3 Tiefpässe 300, 310, 320, 330 und 340, die jeweils mit einem der digitalen Korrelationssignale K0, K1, K2, K3 und Kn beaufschlagt sind. Die Funktion der Tiefpässe besteht darin, eine zeitliche Mittelwertbildung hervorzurufen.

An den Ausgängen der Tiefpässe entstehen somit Ausgangssignale I0, I1, I2, I3 und In, die den zeitlichen Mittelwert des jeweiligen Korrelationssignals K0 bis Kn angeben.

Die Grenzfrequenz der Tiefpässe ist derart gewählt, dass diese ungefähr der unteren Grenzfrequenz des ersten Verstärkers 30 der Verstärkereinrichtung 20 gemäß der Figur 1 entspricht.

Die an den Ausgängen der Tiefpässe entstehenden zeitlichen Mittelwerte I0 bis In werden in nachgeschaltete Komparatoren 400, 410, 420, 430 und 440 eingespeist, die den jeweils eingangsseitig anliegenden zeitlichen Mittelwert mit einem vorgegebenen Schwellwert S vergleichen. Überschreitet der zeitliche Mittelwert den vorgegebenen Schwellwert S, so wird am Ausgang des Komparators ein binäres Schwellwertsignal mit einem "High"-Pegel erzeugt. Anderenfalls, wenn also der zeitliche Mittelwert des Korrelationssignals den Schwellwert S unterschreitet, wird ein binäres Schwellwertsignal mit einem "Low"-Pegel erzeugt.

Die von den Komparatoren 400, 410, 420, 430 und 440 erzeugten binären Schwellwertsignale tragen in der Figur 3 die Bezugszeichen C0, C1, C2, C3 und Cn.

Der Schwellwert S, der an den Komparatoren anliegt, beträgt vorzugsweise 80% bis 95 % des jeweiligen "High"-Pegels des Datensignals D'.

Um Fehler bei der Bildung der binären Schwellwertsignale zu vermeiden, sollten die Datensignale D vorzugsweise einen Duty-Cycle-Wert von ca. 50 % aufweisen. Dies bedeutet, dass eine ausgewogene Anzahl von "High"-Pegeln und "Low"-Pegeln auftritt. Bei Abweichungen eines Duty-Cycle-Wertes von 50 % kann es nämlich zu Fehlern kommen, wenn eine Signalfolge mit einem kurzen "Low"-Pegel verbunden mit einem langen "High"-Pegel auftritt.

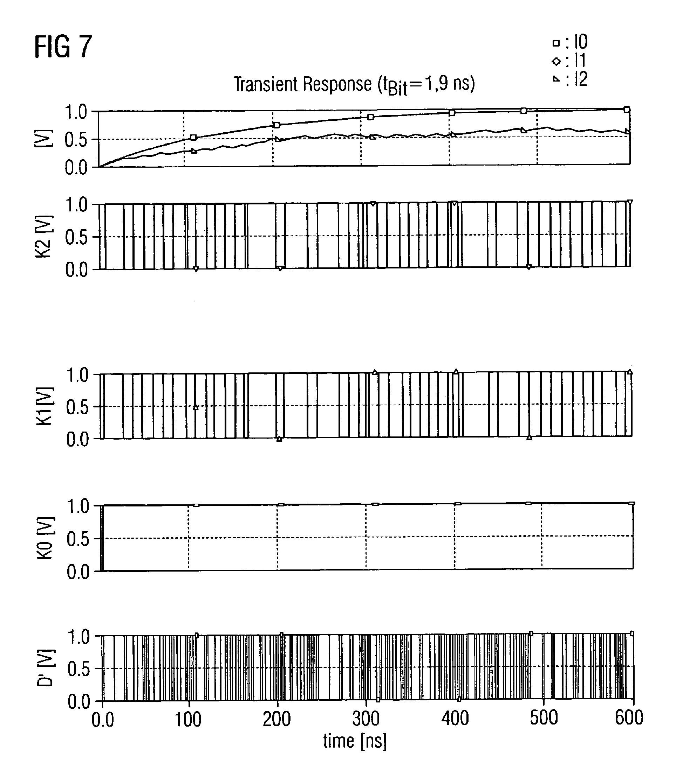

Jedes Korrelationssignal K0 bis Kn könnte im Übrigen unter bestimmten Umständen die Schwelle S überschreiten, wie nachfolgend beispielhaft anhand des Signals $I_2$ erläutert wird: Eine lange Folge von "High"-Pegeln lässt eine ansteigende Rampe am Signal $I_2$ entstehen, selbst wenn diese lange High"-Pegel-Folge gelegentlich von kürzeren Low-Pegel-Folgen unterbrochen wird. Wenn die High-Pegel innerhalb einer bestimmten Zeitspanne überwiegen, würde die ansteigende Rampe die Schwelle "S" erreichen. Dies ist beispielsweise im Zusammenhang mit der Figur 7 erkennbar, in der der Verlauf des Signals $I_2$ dargestellt ist. Wenn nun innerhalb einer bestimmten Zeitspanne die Zahl der High-Pegel und der Low-Pegel ausgeglichen wird (Duty-Cycle-Wert: 50 %), lässt sich vermeiden, dass die Schwelle S erreicht wird. Damit dieser Ausgleich stattfindet, bevor das Signal $I_2$ die Schwelle S erreichen kann, wird die Zeitkonstante der Tiefpässe 300, 310, 320, 330 und 340 derart gewählt, dass sie derjenigen Zeitspanne entspricht, in der sich die Zahl der High-Pegel und der Low-Pegel ausgleicht.

Die Filterung kann mit einem analogen oder einem digitalen Tiefpass durchgeführt werden; eine digitale Filterung kann erfolgen, indem z.B. die Pulslängen der Korrelationssignale K0 bis Kn ausgemessen werden.

In der Figur 3 ist erkennbar, dass die binären Schwellwertsignale C0 bis Cn die Datenrate f des Datensignals D' charakterisieren und somit ein Datenrate-Messsignal bilden. Dieses Datenrate-Messsignal liegt in einem "Thermometer-Code" vor.

Je größer die Anzahl der einen logischen "High"-Pegel aufweisenden binären Schwellwertsignale C0 bis Cn ist, desto niedriger ist die Datenrate f des Datensignals D'. Je geringer hingegen die Anzahl der einen logischen "High"-Pegel aufweisenden binären Schwellwertsignale C0 bis Cn ausfällt, umso geringer ist die Bitlänge $t_{Bit}$ des Datensignals D' und umso höher ist die Datenrate f des Datensignals D'. Gemeinsam bilden also die binären Schwellwertsignale C0 bis Cn ein Datenrate-Messsignal im Thermometer-Code.

In der Figur 3 ist ein Decoder 450 erkennbar, an dem die binären Schwellwertsignale C0 bis Cn eingangsseitig anliegen. Die Funktion des Decoders 450 besteht darin, das durch die binären Schwellwertsignale C0 bis Cn gebildete und im Thermometer-Code vorliegende Datenrate-Messsignal umzucodieren und ausgangsseitig das bereits im Zusammenhang mit der Figur 1 erläuterte Datenrate-Messsignal S[0:m] sowie das Monitorausgangssignal M[x:0] zu bilden.

Nachfolgend soll nun die Funktion der State Machine 90 erläutert werden, die in der Figur 1 dargestellt ist. Am Eingang E90 der State Machine 90 liegt das seitens der Bandbreiten-Kontrolleinrichtung 80 erzeugte Datenrate-Messsignal S[0:m] an. Die State Machine 90 weiß somit also, welche Datenrate f das Datensignal D am Eingang der optischen Empfängerschaltung hat. Im Normalbetrieb schaltet die State Machine 90 das eingangsseitig anliegende Datenrate-Messsignal S[O:m] an seinen Ausgang A90 durch und bildet ausgangsseitig das codierte Steuersignal ST, das dem Datenrate-Messsignal S[0:m] der Bandbreiten-Kontrolleinrichtung 80 entspricht.

Um nun zu verhindern, dass bei einem Neu-Inbetriebnehmen der Empfängerschaltung eine Fehleinstellung des Verstärkers 30 erfolgen kann, ist die State Machine 90 derart ausgestaltet, dass sie bei einem am Steuereingang S90 anliegenden "Power on"-Signal die Ansteuerung des Verstärkers 30 stets mit der größten Datenrate beginnt. Dadurch ist gewährleistet, dass der Verstärker 30 zunächst mit der größten Bandbreite betrieben wird und somit das maximal mögliche Eingangsspektrum des Datensignals D verstärkt wird.

Stellt die State Machine 90 im weiteren Verlauf nach der Inbetriebnahme fest, dass das Datensignal D tatsächlich eine kleinere Datenrate als zuvor angenommen aufweist, so wird sie im Rahmen der nachfolgenden Regelung mit Hilfe des Steuersignals ST derart auf den Verstärker 30 einwirken, dass die Bandbreite des Verstärkers 30 peu à peu an die tatsächliche Datenrate f des Datensignals D herangeführt wird. In dieser Weise wird erreicht, dass der Verstärker 30 ausschließlich mit der minimal erforderlichen Bandbreite betrieben wird.

Durch das Heranführen der Bandbreite des Verstärkers 30 an die gemessene Datenrate f wird vermieden, dass der Verstärker 30 anfangs mit einer zu kleinen Bandbreite betrieben wird. Ein Betrieb mit einer zu kleinen Bandbreite könnte nämlich im ungünstigsten Fall zur Folge haben, dass das verstärkte Datensignal D' ein viel zu kleines Frequenzspektrum aufweist, so dass sich die tatsächliche Datenrate des unverstärkten Datensignals D nicht mehr mittels des verstärkten Datensignals D' ermitteln lässt.

Um derartige Messfehler zu vermeiden, kann die Steuereinrichtung 60 alternativ auch mit dem unverstärkten Datensignal D beaufschlagt werden und dessen Datenrate messen. Die Ansteuerung der Verstärkereinrichtung 20 ist unabhängig davon, ob die Datenrate anhand des verstärkten oder anhand des unverstärkten Datensignals ermittelt wird.

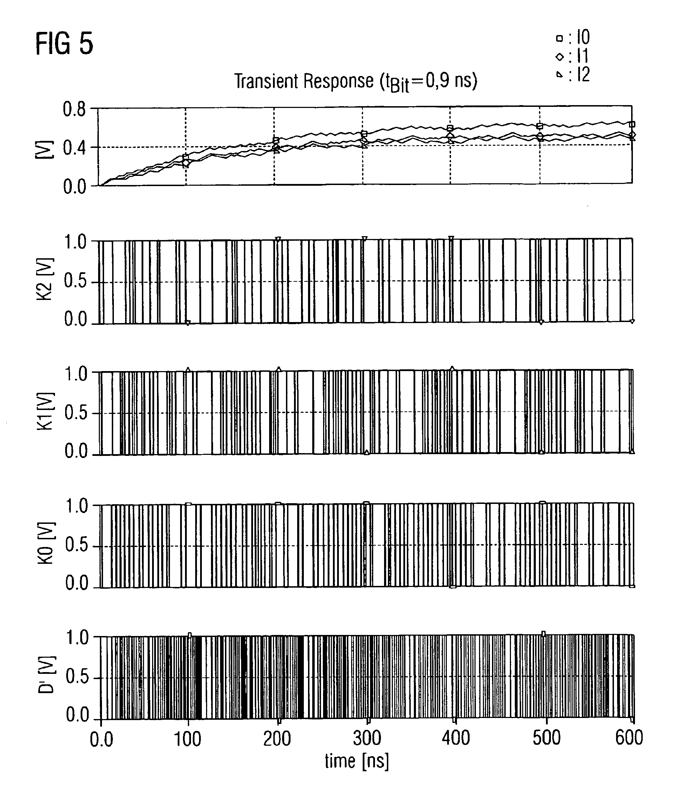

In den Figuren 5 bis 10 sind Simulationsergebnisse einer Empfängerschaltung dargestellt, die der Empfängerschaltung gemäß den Figuren 1 bis 4 bis auf wenige Modifikationen identisch entspricht. Zum Zwecke der Simulation wurden folgende Annahmen getroffen:

1. Als Datensignal D wird eine Pseudozufallsfolge von 127 Bit verwendet.

2. Der Datenkorrelator 70 sowie die Bandbreiten-Kontrolleinrichtung 80 sind jeweils dreistufig aufgebaut. Dies bedeutet, dass der Datenkorrelator 70 drei Phasenschieber sowie drei D-Flip-Flops und die Bandbreiten-Kontrolleinrichtung 80 drei Tiefpässe mit drei Komparatoren enthält. Im Gegensatz zu den Erläuterungen gemäß den Figuren 2 bis 4, bei denen ein fünfstufiger Aufbau erläutert wurde, ist im Zusammenhang mit den Figuren 5 bis 10 also nur ein dreistufiger Aufbau simuliert.

3. Die Grenzfrequenz der Tiefpässe der Bandbreiten-Kontrolleinrichtung 80 beträgt jeweils 1 MHz.

4. Dem "High"-Pegel ist eine logische "1" zugeordnet.

5. Dem "Low"-Pegel ist eine logische "0" zugeordnet.

6. Die Phasenschieber 100, 110 und 120 bewirken jeweils eine Phasenverschiebung von 1 ns.

In den Figuren 5 bis 10 ist jeweils im untersten Diagramm der zeitliche Verlauf des verstärkten Datensignals D' eingezeichnet.

In dem darüber liegenden Diagramm ist der zeitliche Verlauf des Korrelationssignals K0 gemäß den Figuren 2 und 3 gezeigt.

In dem mittleren Diagramm der Figuren 5 bis 10 ist jeweils der zeitliche Verlauf des Korrelationssignals K1 gemäß den Figuren 2 und 3 gezeigt.

In dem von oben gesehenen zweiten Diagramm ist das dritte Korrelationssignal K2 gemäß den Figuren 2 und 3 dargestellt.

In dem obersten Diagramm der Figuren 5 bis 10 ist der zeitliche Verlauf der zeitlichen Mittelwerte I0, I1 und I2 der Korrelationssignale K0 bis K2 eingezeichnet.

In der Figur 5 sind die resultierenden Signalverläufe für den Fall dargestellt, dass die Datenrate f des Datensignals D' 1,1 GBit/s ($t_{Bit}$ = 0,9 ns)beträgt. Aufgrund der zeitlichen Verzögerung der Phasenschieber 100, 110 und 120 von jeweils 1 ns wird nur bei zwei aufeinander folgenden "High"-Pegeln das erste D-Flip-Flop 150 gemäß Figur 2 getriggert und bei isolierten Bits zurückgesetzt. Daher ist der zeitliche Mittelwert I0 des Korrelationssignals K0 des ersten D-Flip-Flops 150 etwas höher als die zeitlichen Mittelwerte I1 und I2 der beiden D-Flip-Flops 160 und 170.

Keiner der zeitlichen Mittelwerte I0 bis I2 erreicht jedoch den "High"-Pegel von 1 Volt.

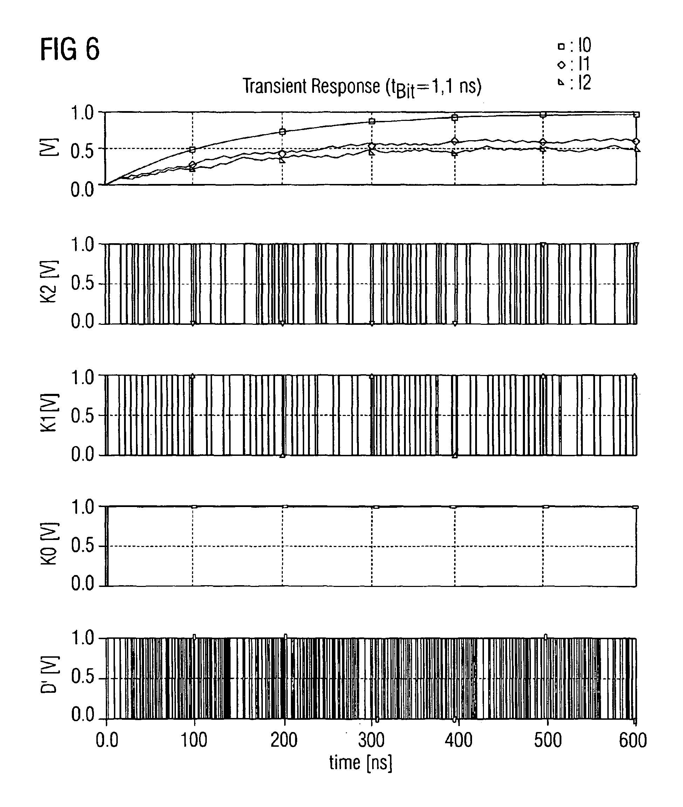

In der Figur 6 sind die Signalverläufe für eine Datenrate f = 0,9 Gbit/s des Datensignals D' eingezeichnet ($t_{Bit}$ = 1,1 ns). Aufgrund der eingestellten Verzögerung der drei Phasenschieber 100, 110 und 120 von jeweils 1 ns wird das erste D-Flip-Flop 150 sicher getriggert und nicht mehr zurückgesetzt. Daher erreicht der zeitliche Mittelwert des Korrelationssignals K0 den "High"-Pegel von 1 Volt.

Die beiden anderen zeitlichen Mittelwerte I1 und I2 der beiden Korrelationssignale K1 und K2 erreichen den "High"-Pegel jedoch nicht.

In der Figur 7 sind die Signalverläufe für eine Datenrate f von 0,52 Gbit/s eingetragen. Diese Datenrate f entspricht einer Bitlänge $t_{Bit}$ von 1,9 ns. Aufgrund der eingestellten Verzögerung der drei Phasenschieber 100, 110 und 120 von jeweils 1 ns wird das erste D-Flip-Flop 150 sicher getriggert und nicht mehr zurückgesetzt. Daher erreicht der zeitliche Mittelwert I0 des Korrelationssignals K0 den "High"-Pegel von 1 Volt.

Die beiden zeitlichen Mittelwerte I1 und I2 der beiden Korrelationssignale K1 und K2 erreichen den "High"-Pegel jedoch nicht. In der Figur 7 sind die beiden zeitlichen Mittelwerte I1 und I2 zirka gleich groß; dies ist jedoch schwer zu erkennen, da deren Markierungen bzw. Symbole "Dreieck" und "Raute" übereinander gezeichnet sind.

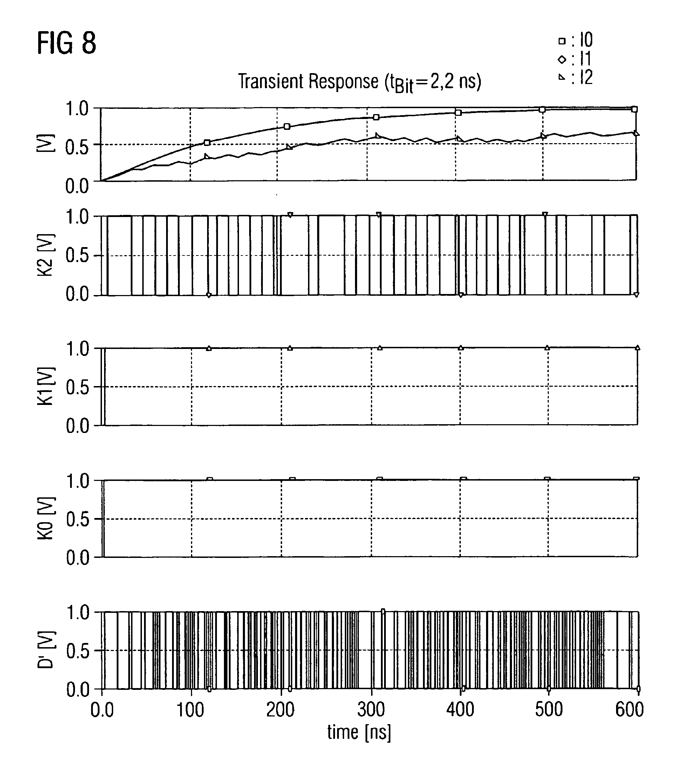

In der Figur 8 ist das Simulationsergebnis der Signalverläufe für eine Datenrate f von 0,45 Gbit/s dargestellt. Diese Datenrate entspricht einer Bitlänge $t_{Bit}$ von 2,2 ns. Aufgrund der Verzögerung der Phasenschieber 100, 110 und 120 werden das erste und das zweite D-Flip-Flop 150 und 160 sicher getriggert und nicht mehr zurückgesetzt. Daher erreichen die beiden zeitlichen Mittelwerte I0 und I1 der beiden Korrelationssignale K0 und K1 jeweils den "High"-Pegel von 1 Volt.

Der zeitliche Mittelwert I2 des Korrelationssignals K2 erreicht den "High"-Pegel jedoch nicht.

Die beiden Signale I0 und I1 sind gleich groß, so dass sie in der Figur 8 voneinander schlecht zu trennen sind, da deren Markierungen "Quadrat" und "Raute" übereinander geplottet sind.

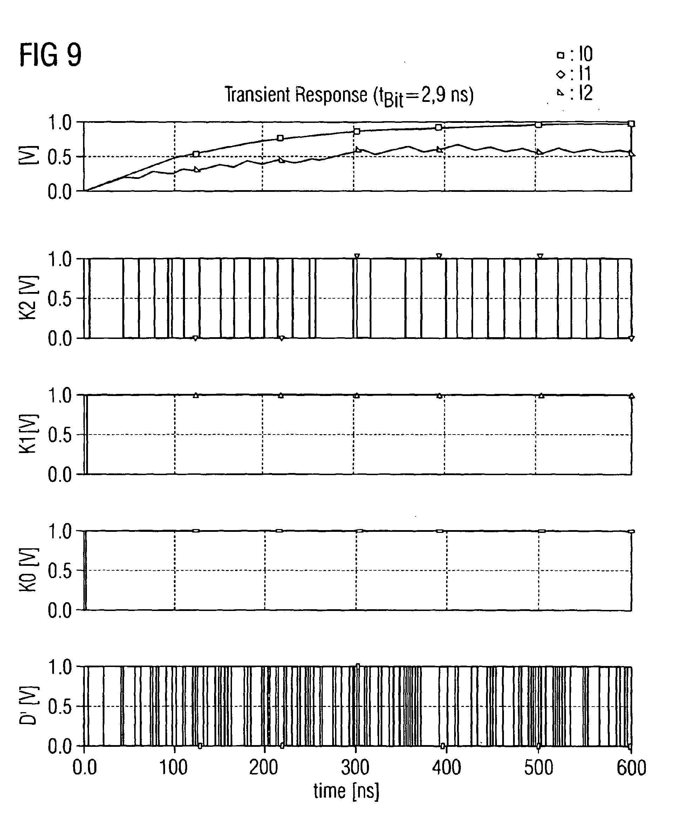

In der Figur 9 sind die zeitlichen Verläufe für eine Datenrate f des Datensignals D von 0,345 Gbit/s dargestellt. Diese Datenrate f entspricht einer Bitlänge von 2,9 ns. Vom Ergebnis her entsprechen die zeitlichen Verläufe den bereits im Zusammenhang mit der Figur 8 erläuterten zeitlichen Verläufen.

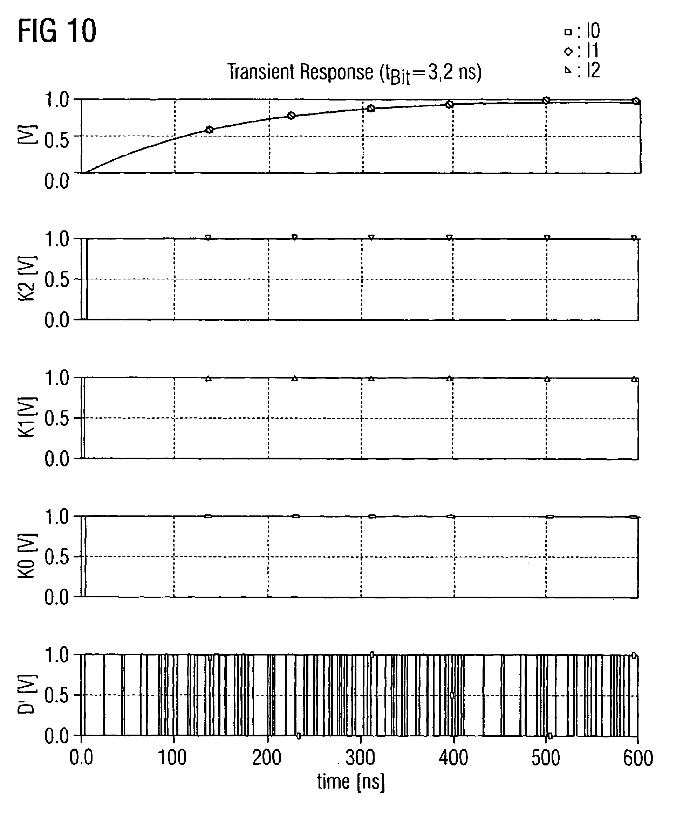

In der Figur 10 ist das Simulationsergebnis der Signalverläufe für eine Datenrate des Datensignals von 0,312 Gbit/s dargestellt. Diese Datenrate entspricht einer Bitlänge $t_{Bit}$ von 3,2 ns. Aufgrund der Verzögerung der Phasenschieber 100, 110 und 120 gemäß der Figur 2 von jeweils einer 1 ns werden alle drei D-Flip-Flops 150, 160 und 170 sicher getriggert und nicht mehr zurückgesetzt. Alle drei zeitlichen Mittelwerte I0, I1 und I2 der Korrelationssignale K0, K1 und K2 erreichen somit den "High"-Pegel von 1 Volt.

Zusammengefasst ist damit festzustellen, dass mit dem beschriebenen Verfahren bzw. mit der beschriebenen Datenrate-Messanordung ein sicheres Bestimmen der Datenrate möglich ist. Erreicht nämlich der zeitliche Mittelwert I0 bis In eines der Korrelationssignale K0 bis Kn den "High"-Pegel von 1 Volt, so muss die Bitlänge des Datensignals D' größer als die jeweilige Phasenverzögerung des Korrelationssignals sein.

Nach dem Bestimmen der Bitlänge $t_{Bit}$ lässt sich dann auch die Datenrate f ermitteln, da die Datenrate f und die Bitlänge invers miteinander verknüpft sind:

$$f = 1 / t_{Bit}$$

Beträgt also beispielsweise die Phasenverschiebung des Phasenschiebers 100 t0 = 1 ns und erreicht der zugeordnete zeitliche Mittelwert I0 des digitalen Korrelationssignals K0 den "High"-Pegel von einem Volt, so muss die Datenrate kleiner als 1 Gbit/s sein.

Im Prinzip kann durch eine sehr fein abgestufte Verzögerungskette, also durch eine Vielzahl an Phasenschiebern, D-Flip-Flops, Tiefpässen und Komparatoren (vgl. Figuren 2 und 3) eine sehr hohe Auflösung bei der Datenrate-Messung erfolgen. Als Ergebnis erhält man ein Datenrate-Messsignal in einem Thermometer-Code. Zur Umcodierung dieses Thermometer-Codes wird - sofern gewünscht - ein Thermometer-Decoder verwendet.

Wie sich in den Figuren 5 bis 10 erkennen lässt, sollte der Schwellwert bevorzugt in einem Bereich zwischen dem 0,8-fachen und dem 0,95-fachen des "High"-Pegels des Datensignals D liegen, um eine zuverlässige Datenrate-Bestimmung zu ermöglichen.

Im Zusammenhang mit dem Ausführungsbeispiel gemäß den Figuren 1 bis 10 wurde beispielhaft davon ausgegangen, dass die Phasenschieber 100, 110, 120, 130 und 135 dieselbe Phasenverschiebung bewirken. Alternativ kann die Phasenverschiebung der Phasenschieber untereinander auch unterschiedlich sein, beispielsweise können die Phasenverschiebungswerte logarithmisch gestaffelt sein.

Bezugszeichenliste

| | |
|---|---|
| 10 | optische Empfängerschaltung |
| 20 | Verstärkereinrichtung |
| 30 | steuerbarer Verstärker |
| 40 | Verstärker |
| 50 | Verstärker |
| 60 | Steuereinrichtung |
| 70 | Datenkorrelator |
| 80 | Bandbreitenkontroll-Einrichtung |
| 90 | State Machine |
| 100,110,120,130,135 | Phasenschieber |
| 140 | Punkte |
| 150,160,170,180,190 | D-Flip-Flops |
| 300,310,320,330,340 | Tiefpässe |
| 400,410,420,430,440 | Komparatoren |
| 450 | Decoder |

**Patentansprüche**

1. Empfängerschaltung (10)

   - mit mindestens einer Verstärkereinrichtung (20) zum Verstärken eines eingangsseitig an der Empfängerschaltung (10) anliegenden Datensignals und
   - mit einer Steuereinrichtung (60), die die Datenrate des Datensignals misst und die Bandbreite der Verstärkereinrichtung (20) derart einstellt, dass die Bandbreite der Verstärkereinrichtung (20) der Datenrate des Datensignals entspricht,

   **dadurch gekennzeichnet, dass**
   die Steuereinrichtung (60) eingangsseitig einen Datenkorrelator (70), der

   - mit dem Datensignal oder mit dem mit der Verstärkereinrichtung (20) verstärkten Datensignal eingangsseitig beaufschlagt ist,
   - das Datensignal einer Autokorrelation unterwirft und
   - ausgangsseitig zumindest ein dem Korrelationsergebnis entsprechendes digitales Korrelationssignal zur Bestimmung der Datenrate des Datensignals erzeugt,
   sowie eine Bandbreiten-Kontrolleinrichtung (80) aufweist, die
   - dem Datenkorrelator (70) nachgeordnet ist,
   - das digitale Korrelationssignal zeitlich mittelt und
   - aus dem gemittelten Korrelationssignal des Datenkorrelators ein Datenrate-Messsignal zur Ansteuerung der Verstärkereinrichtung erzeugt.

2. Empfängerschaltung nach Anspruch 1, **dadurch gekennzeichnet, dass** der Datenkorrelator (70) zur Bildung des digitalen Korrelationssignals

    - mit dem Datensignal zumindest ein phasenverschobenes Hilfssignal bildet und
    - das Datensignal und das zumindest eine phasenverschobene Hilfssignal einer Korrelation unterwirft.

3. Empfängerschaltung nach Anspruch 2, **dadurch gekennzeichnet, dass** der Datenkorrelator (70) zur Bildung des zumindest einen phasenverschobenen Hilfssignals einen Phasenschieber (100, 110, 120, 130, 135) und zur Bildung des zumindest einen Korrelationssignals ein D-Flip-Flop (150, 160, 170, 180, 190) aufweist.

4. Empfängerschaltung nach Anspruch 3, **dadurch gekennzeichnet, dass** der Datenkorrelator (70) eine Mehrzahl an Korrelationssignalen erzeugt, die unter Heranziehung einer Mehrzahl an phasenverschobenen Hilfssignalen mit gegenüber dem Datensignal unterschiedlicher Phasenverschiebung gebildet werden.

5. Empfängerschaltung nach Anspruch 4, **dadurch gekennzeichnet, dass** die Bandbreiten-Kontrolleinrichtung (80) derart ausgestaltet ist, dass sie die Korrelationssignale jeweils zeitlich mittelt und mit jedem gemittelten Korrelationssignal jeweils ein binäres Schwellwertsignal erzeugt, das angibt, ob der zeitliche Mittelwert des jeweiligen Korrelationssignals kleiner oder größer als ein vorgegebener Schwellwert sind.

6. Empfängerschaltung nach Anspruch 5, **dadurch gekennzeichnet, dass** die Bandbreiten-Kontrolleinrichtung (80) zur zeitlichen Mittlung der Korrelationssignale jeweils einen Tiefpass und zur Bildung der binären Schwellwertsignale jeweils einen Komparator aufweist.

7. Empfängerschaltung nach Anspruch 5, **dadurch gekennzeichnet, dass** die Steuereinrichtung (60) eine der Bandbreiten-Kontrolleinrichtung (80) nachgeordnete State Machine (90) aufweist, die unter Berücksichtigung des Datenrate-Messsignals der Bandbreiten-Kontrolleinrichtung die Verstärkereinrichtung ansteuert.

8. Empfängerschaltung nach Anspruch 1, **dadurch gekennzeichnet, dass** die Empfängerschaltung (10) zusätzlich eine Umschaltvorrichtung zum Umschalten des Rauschens bzw. zum Verändern des Rauschverhaltens der Verstärkereinrichtung aufweist.

9. Empfängerschaltung nach Anspruch 8, **dadurch gekennzeichnet, dass** die Umschaltvorrichtung derart ausgestaltet ist, dass sie durch ein Umschalten oder Verändern des Arbeitspunktes der Verstärkereinrichtung die Empfindlichkeit der Empfängerschaltung optimiert.

10. Verfahren zum Betreiben einer Empfängerschaltung (10), bei dem

    - ein Datensignal mit einer Verstärkereinrichtung (20) unter Bildung eines verstärkten Datensignals verstärkt wird,
    - die Datenrate des Datensignals oder die des verstärkten Datensignals gemessen wird
    - und die Bandbreite der Verstärkereinrichtung (20) derart eingestellt wird, dass die Bandbreite der Verstärkereinrichtung (20) der gemessenen Datenrate entspricht,

**dadurch gekennzeichnet, dass**
die Datenrate gemessen wird, indem

    - das Datensignal einer Autokorrelation unter Bildung zumindest eines digitalen Korrelationssignals unterzogen wird,
    - das zumindest eine digitale Korrelationssignal zeitlich gemittelt wird und
    - mit dem zeitlichen Mittelwert ein die Datenrate des Datensignals charakterisierendes Datenratemesssignal erzeugt wird.

11. Verfahren nach Anspruch 10, **dadurch gekennzeichnet, dass** die Autokorrelation durchgeführt wird, indem

    - das Datensignal unter Bildung mindestens eines phasenverschobenen Hilfssignals phasenverschoben wird und
    - das Datensignal und das zumindest eine phasenverschobene Hilfssignal unter Bildung des zumindest einen Korrelationssignals korreliert werden.

**12.** Verfahren nach Anspruch 11, **dadurch gekennzeichnet, dass** die Korrelation des Datensignals und des mindestens einen phasenverschobenen Hilfssignals mit einem D-Flip-Flop erfolgt, indem

- das Datensignal an einem D-Eingang des D-Flip-Flops eingespeist wird und
- das D-Flip-Flop mit dem mindestens einen phasenverschobenen Hilfssignal auf positive oder negative Flanken getriggert wird, wodurch am Ausgang des D-Flip-Flops das der Phasenverschiebung des Hilfssignals entsprechende Korrelationssignal gebildet wird.

**13.** Verfahren nach Anspruch 11, **dadurch gekennzeichnet, dass** mit dem zeitlichen Mittelwert des zumindest einen Korrelationssignals ein binäres Schwellwertsignal erzeugt wird, das angibt, ob der zeitliche Mittelwert des zumindest einen Korrelationssignals kleiner oder größer als ein vorgegebener Schwellwert sind.

**14.** Verfahren nach Anspruch 13, **dadurch gekennzeichnet, dass** der zeitliche Mittelwert des zumindest einen Korrelationssignals jeweils mittels eines Tiefpasses gebildet wird.

**15.** Verfahren nach Anspruch 14, **dadurch gekennzeichnet, dass** das Schwellwertsignal mit einem Komparator gebildet wird, indem dieser mit dem zeitlichen Mittelwert des Korrelationssignals sowie mit dem vorgegebenen Schwellwert beaufschlagt wird.

**16.** Verfahren nach Anspruch 11, **dadurch gekennzeichnet, dass**

- eine Mehrzahl an phasenverschobenen Hilfssignalen erzeugt wird, die gegenüber dem Datensignal unterschiedlich phasenverschoben sind, und
- mit jedem Hilfssignal jeweils ein digitales Korrelationssignal und ein binäres Schwellwertsignal erzeugt wird.

**17.** Verfahren nach Anspruch 16, **dadurch gekennzeichnet, dass** mit den Schwellwertsignalen das Datenrate-Messsignal in einem Thermometer-Code erzeugt wird.

## Claims

**1.** Receiver circuit (10)

- having at least one amplifier device (20) for amplification of a data signal which is applied to the input side of the receiver circuit (10), and
- having a control device (60) which measures the data rate of the data signal and sets the bandwidth of the amplifier device (20) such that the bandwidth of the amplifier device (20) corresponds to the data rate of the data signal,

**characterized in that**
the control device (60) has a data correlator (70) on the input side,

- to whose input side the data signal or the data signal which has been amplified by the amplifier device (20) is applied,
- which subjects the data signal to autocorrelation, and
- which produces at least one digital correlation signal, which corresponds to the correlation result, on the output side in order to determine the data rate of the data signal,
as well as a bandwidth monitoring device (80), which
- is arranged downstream from the data correlator (70),
- averages the digital correlation signal over time, and
- uses the averaged correlation signal from the data correlator to produce a data-rate measurement signal for driving the amplifier device.

**2.** Receiver circuit according to Claim 1,
**characterized in that**, in order to form the digital correlation signal, the data correlator (70)

- forms at least one phase-shifted auxiliary signal with the data signal, and
- subjects the data signal and the at least one phase-shifted auxiliary signal to a correlation.

3. Receiver circuit according to Claim 2, **characterized in that** the data correlator (70) has a phase shifter (100, 110, 120, 130, 135) in order to form the at least one phase-shifted auxiliary signal, and has a D-flipflop (150, 160, 170, 180, 190) in order to form the at least one correlation signal.

4. Receiver circuit according to Claim 3, **characterized in that** the data correlator (70) produces two or more correlation signals which are formed using a plurality of phase-shifted auxiliary signals with a different phase shift with respect to the data signal.

5. Receiver circuit according to Claim 4, **characterized in that** the bandwidth monitoring device (80) is designed such that it averages each of the correlation signals over time and uses each averaged correlation signal to produce a respective binary threshold value signal, which indicates whether the time mean value of the respective correlation signal is less than or greater than a predetermined threshold value.

6. Receiver circuit according to Claim 5, **characterized in that** the bandwidth monitoring device (80) has one low-pass filter respectively for time averaging of the correlation signals, and has one comparator respectively for forming the binary threshold value signals.

7. Receiver circuit according to Claim 5, **characterized in that** the control device (60) has a state machine (90) which is arranged downstream from the bandwidth monitoring device (80) and drives the amplifier device taking account of the data rate measurement signal from the bandwidth monitoring device.

8. Amplifier circuit according to Claim 1, **characterized in that** the receiver circuit (10) additionally has a switching apparatus for switching the noise and for varying the noise response of the amplifier device.

9. Receiver circuit according to Claim 8, **characterized in that** the switching apparatus is designed such that it optimizes the sensitivity of the receiver circuit by switching or varying the operating point of the amplifier device.

10. Method for operation of a receiver circuit (10), in which

- a data signal is amplified by an amplifier device (20) forming an amplified data signal,
- the data rate of the data signal or that of the amplified data signal is measured,
- and the bandwidth of the amplifier device (20) is set such that the bandwidth of the amplifier device (20) corresponds to the measured data rate,

**characterized in that** the data rate is measured **in that**

- the data signal is subjected to autocorrelation forming at least one digital correlation signal,
- the at least one digital correlation signal is averaged over time, and
- the time mean value is used to produce a data rate measurement signal which characterizes the data rate of the data signal.

11. Method according to Claim 10, **characterized in that** the autocorrelation is carried out **in that**

- the data signal is phase-shifted forming at least one phase-shifted auxiliary signal, and
- the data signal and the at least one phase-shifted auxiliary signal are correlated, forming the at least one correlation signal.

12. Method according to Claim 11, **characterized in that** the correlation of the data signal and of the at least one phase-shifted auxiliary signal is carried out using a D flipflop **in that**

- the data signal is fed in at a D input of the D flipflop, and
- the D flipflop is triggered to positive or negative flanks by the at least one phase-shifted auxiliary signal, as a result of which the correlation signal which corresponds to the phase shift of the auxiliary signal is formed at the output of the D flipflop.

13. Method according to Claim 11, **characterized in that** the time mean value of the at least one correlation signal is used to produce a binary threshold value signal which indicates whether the time mean value of the at least one correlation signal is less than or greater than a predetermined threshold value.

**14.** Method according to Claim 13, **characterized in that** the time mean value of the at least one correlation signal is in each case formed by means of a low-pass filter.

**15.** Method according to Claim 14, **characterized in that** the threshold value signal is formed by means of a comparator, by applying the time mean value of the correlation signal as well as the predetermined threshold value to this comparator.

**16.** Method according to Claim 11, **characterized in that**

- a plurality of phase-shifted auxiliary signals are produced which are phase-shifted differently with respect to the data signal, and
- a digital correlation signal and a binary threshold value signal are in each case produced with each auxiliary signal.

**17.** Method according to Claim 16, **characterized in that** the data rate measurement signal is produced in a thermometer code using the threshold value signals.

## Revendications

**1.** Circuit récepteur (10)

- comprenant au moins un dispositif amplificateur (20) pour amplifier un signal de données appliqué à l'entrée du circuit récepteur (10) et
- comprenant un dispositif de commande (60) qui mesure le débit des données du signal de données et règle la bande passante du dispositif amplificateur (20) de telle sorte que la bande passante du dispositif amplificateur (20) correspond au débit des données du signal de données,

**caractérisé en ce que**
le dispositif de commande (60) présente du côté de l'entrée un corrélateur de données (70) qui

- reçoit en entrée le signal de données ou le signal de données amplifié avec le dispositif d'amplification (20),
- soumet le signal de données à une auto-corrélation et
- génère en sortie au moins un signal de corrélation numérique correspondant au résultat de la corrélation en vue de déterminer le débit des données du signal de données,

ainsi qu'un dispositif de contrôle des bandes passantes (80) qui

- est branché à la suite du corrélateur de données (70),
- calcule une moyenne dans le temps du signal de corrélation numérique et
- génère à partir de la moyenne du signal de corrélation du corrélateur de données un signal de mesure du débit des données en vue de commander le dispositif amplificateur.

**2.** Circuit récepteur selon la revendication 1, **caractérisé en ce que** le corrélateur de données (70), pour former le signal de corrélation numérique,

- forme avec le signal de données au moins un signal auxiliaire déphasé et
- soumet le signal de données et l'au moins un signal auxiliaire déphasé à une corrélation.

**3.** Circuit récepteur selon la revendication 2, **caractérisé en ce que** le corrélateur de données (70) présente un déphaseur (100, 110, 120, 130, 135) pour former l'au moins un signal auxiliaire déphasé et une bascule bistable D (150, 160, 170, 180, 190) pour former l'au moins un signal de corrélation.

**4.** Circuit récepteur selon la revendication 3, **caractérisé en ce que** le corrélateur de données (70) génère une pluralité de signaux de corrélation qui sont formés en faisant intervenir une pluralité de signaux auxiliaire déphasés présentant un déphasage différent par rapport au signal de données.

**5.** Circuit récepteur selon la revendication 4, **caractérisé en ce que** le dispositif de contrôle des bandes passantes (80) est configuré de telle sorte qu'il calcule à chaque fois la moyenne dans le temps des signaux de corrélation et génère avec chaque moyenne du signal de corrélation à chaque fois un signal de valeur de seuil binaire qui indique si la valeur moyenne dans le temps du signal de corrélation correspondant est inférieure ou supérieure à une valeur de seuil prédéfinie.

6. Circuit récepteur selon la revendication 5, **caractérisé en ce que** le dispositif de contrôle des bandes passantes (80) présente à chaque fois un filtre passe-bas pour le calcul de la moyenne dans le temps des signaux de corrélation et à chaque fois un comparateur pour former les signaux de valeur de seuil binaires.

7. Circuit récepteur selon la revendication 5, **caractérisé en ce que** le dispositif de commande (60) présente une machine d'état (90) disposée à la suite du dispositif de contrôle des bandes passantes (80), laquelle commande le dispositif amplificateur en tenant compte du signal de mesure du débit des données du dispositif de contrôle des bandes passantes.

8. Circuit récepteur selon la revendication 1, **caractérisé en ce que** le circuit récepteur (10) présente en plus un dispositif de permutation pour permuter le bruit ou pour modifier les conditions de bruit du dispositif amplificateur.

9. Circuit récepteur selon la revendication 8, **caractérisé en ce que** le dispositif de permutation est configuré de telle sorte qu'il optimise la sensibilité du circuit récepteur par une permutation ou une modification du point de fonctionnement du dispositif amplificateur.

10. Procédé de fonctionnement d'un dispositif récepteur (10) avec lequel

   - un signal de données est amplifié avec au moins un dispositif amplificateur (20) en formant un signal de données amplifié,
   - le débit des données du signal de données ou du signal de données amplifié est mesuré,
   - et la bande passante du dispositif amplificateur (20) est réglée de telle sorte que la bande passante du dispositif amplificateur (20) correspond au débit de données mesuré

   **caractérisé en ce que**
   le débit des données est mesuré **en ce que**

   - le signal de données est soumis à une auto-corrélation en formant au moins un signal de corrélation numérique,
   - une moyenne dans le temps de l'au moins un signal de corrélation numérique est calculée
   - un signal de mesure de débit des données caractérisant le débit des données du signal de données est généré avec la valeur moyenne dans le temps.

11. Procédé selon la revendication 10, **caractérisé en ce que** l'auto-corrélation est effectuée **en ce que**

   - le signal de données est déphasé en formant au moins un signal auxiliaire déphasé et
   - le signal de données et l'au moins un signal auxiliaire déphasé sont corrélés en formant l'au moins un signal de corrélation.

12. Procédé selon la revendication 11, **caractérisé en ce que** la corrélation du signal de données et de l'au moins un signal auxiliaire déphasé s'effectue avec une bascule bistable D **en ce que**

   - le signal de données est injecté sur une entrée D de la bascule bistable D et
   - la bascule bistable D est déclenchée sur des fronts positifs ou négatifs avec l'au moins un signal auxiliaire déphasé, le signal de corrélation correspondant au déphasage du signal auxiliaire étant formé à la sortie de la bascule bistable D.

13. Procédé selon la revendication 11, **caractérisé en ce qu'**avec la valeur moyenne dans le temps de l'au moins un signal de corrélation est généré un signal de valeur de seuil qui indique si la valeur moyenne dans le temps de l'au moins un signal de corrélation est inférieure ou supérieure à une valeur de seuil prédéfinie.

14. Procédé selon la revendication 13, **caractérisé en ce que** la valeur moyenne dans le temps de l'au moins un signal de corrélation est à chaque fois formée au moyen d'un filtre passe-bas.

**15.** Procédé selon la revendication 14, **caractérisé en ce que** le signal de valeur de seuil est formé avec un comparateur en soumettant celui-ci à la valeur moyenne dans le temps du signal de corrélation ainsi qu'à la valeur de seuil prédéfinie.

**16.** Procédé selon la revendication 11, **caractérisé en ce que**

- une pluralité de signaux auxiliaires déphasés est générée, lesquels sont déphasés différemment par rapport au signal de données et
- un signal de corrélation numérique et un signal de valeur de seuil binaire sont formés respectivement avec chaque signal auxiliaire.

**17.** Procédé selon la revendication 16, **caractérisé en ce que** le signal de mesure du débit de données est généré dans un code de thermomètre avec les signaux de valeur de seuil.

FIG 1

# FIG 2

# FIG 3

# FIG 4

# FIG 5

□ : I0
◇ : I1
▵ : I2

Transient Response (t$_{Bit}$=0,9 ns)

# FIG 6

□ : I0
◇ : I1
▷ : I2

Transient Response ($t_{Bit}=1,1$ ns)

FIG 7

□ : I0
◇ : I1
▲ : I2

Transient Response ($t_{Bit}$=1,9 ns)

# FIG 8

Transient Response (t$_{Bit}$=2,2 ns)

□ : I0
◇ : I1
▷ : I2

# FIG 9

□ : I0
◇ : I1
▵ : I2

Transient Response ($t_{Bit}=2{,}9$ ns)

# FIG 10

□ : I0
◇ : I1
▲ : I2

Transient Response ($t_{Bit}$=3,2 ns)

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 4608542 A
- US 5864416 A
- US 20020141022 A1
- US 10649409 B